# FASCICULE DE BREVET EUROPEEN

(11) **EP 1 243 169 B1**
(45) Date de publication et mention de la délivrance du brevet: **30.07.2003**
(21) Numéro de dépôt: 00990833.6
(22) Date de dépôt: 28.12.2000
(51) Int. Cl.: H05K 7/20

(54) **MODULE ELECTRONIQUE A HAUT POUVOIR DE REFROIDISSEMENT**
ELEKTRONISCHE BAUGRUPPE MIT HOHEM KÜHLUNGSVERMÖGEN
ELECTRONIC MODULE WITH HIGH COOLING POWER

(30) Priorité: 28.12.1999 FR 9916594
(43) Date de publication de la demande: 25.09.2002
(73) Titulaire: THALES AVIONICS S.A., 78140 Vélizy-Villacoublay (FR)
(72) Inventeur: SARNO, Claude, 94117 Arcueil Cedex (FR); MOULIN, Georges, 94117 Arcueil Cedex (FR)
(74) Mandataire: Guérin, Michel
(86) Numéro de dépôt international: FR0003718
(87) Numéro de publication internationale: WO01049092

(56) Documents cités:
- GB-A- 2 145 290
- GB-A- 2 270 207
- US-A- 4 366 526
- US-A- 5 077 637
- US-A- 5 161 092
- PATENT ABSTRACTS OF JAPAN vol. 009, no. 118 (E-316), 23 mai 1985 (1985-05-23) & JP 60 007154 A (MITSUBISHI DENKI KK), 14 janvier 1985 (1985-01-14)

## Description

L'invention se rapporte au refroidissement de dispositifs électroniques modulaires, notamment mais non exclusivement des dispositifs « embarqués » à bord d'aérodynes, ou de chars, etc.....

Les dispositifs « embarqués » doivent fonctionner dans des conditions d'environnement sévères (vibrations, chocs, humidité, accélérations, difficulté de dissipation thermique).

Ces conditions difficiles peuvent entraîner des pannes. Ceci conduit à concevoir ces matériels électroniques en vue de favoriser leur dépannage et leur maintenance.

L'une des nouvelles normes aéronautiques prévoit de les réaliser sous la forme de structures modulaires appelées LRM, de l'anglais « Line Replaceable Module », soit en français « Module Remplaçable en Ligne », installées dans des racks.

Un rack peut regrouper un nombre important de modules électroniques. Ceci facilite la maintenance, la manutention et le dépannage rapide, mais tend à rendre plus difficile l'évacuation de la chaleur produite par les divers composants contenus dans les modules. Ces composants, de plus en plus sophistiqués, produisent de plus en plus de chaleur. L'invention vise à résoudre le problème de l'évacuation de cette chaleur.

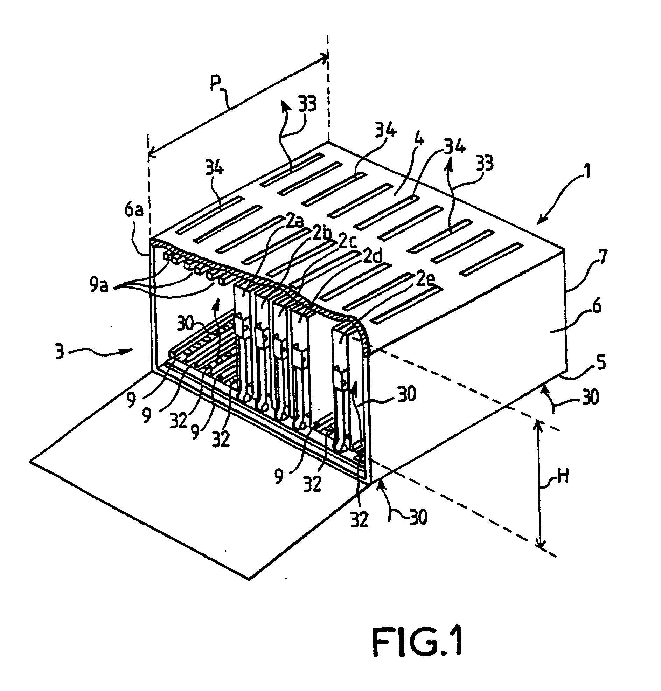

La figure 1 représente en perspective, un rack 1 contenant plusieurs modules électroniques. Le rack 1 est généralement parallélépipédique, avec une face avant 3 pour l'introduction et l'extraction des modules électronique 2a à 2e, et cinq autres faces 4, 5, 6, 6a, 7. La face 7 est constituée par une plaque de fond qui ferme le rack 1 et porte des connecteurs dans lesquels viennent s'enficher les connecteurs correspondants des modules 2a à 2e.

Les plaques inférieure et supérieure 4, 5 portent des glissières par exemple métalliques, respectivement 9, 9a permettant de maintenir et de guider les modules électroniques 2a à 2e dans le rack 1.

Le rack 1 peut comporter des ouvertures permettant une circulation d'air, en vue d'un refroidissement des modules électroniques 2a à 2e. L'air de refroidissement (symbolisé par des flèches repérées 30) est généralement injecté dans le rack au niveau de la plaque inférieure 4, par des ouvertures 32 dites d'entrée d'air situées entre les glissières 9. L'air de refroidissement 30 circule entre les modules 2a à 2e (et éventuellement dans ces modules). L'air 33 chargé de calories sort du rack 1 par des ouvertures de sortie 34, formées entre les glissières 9a de la plaque supérieure 5.

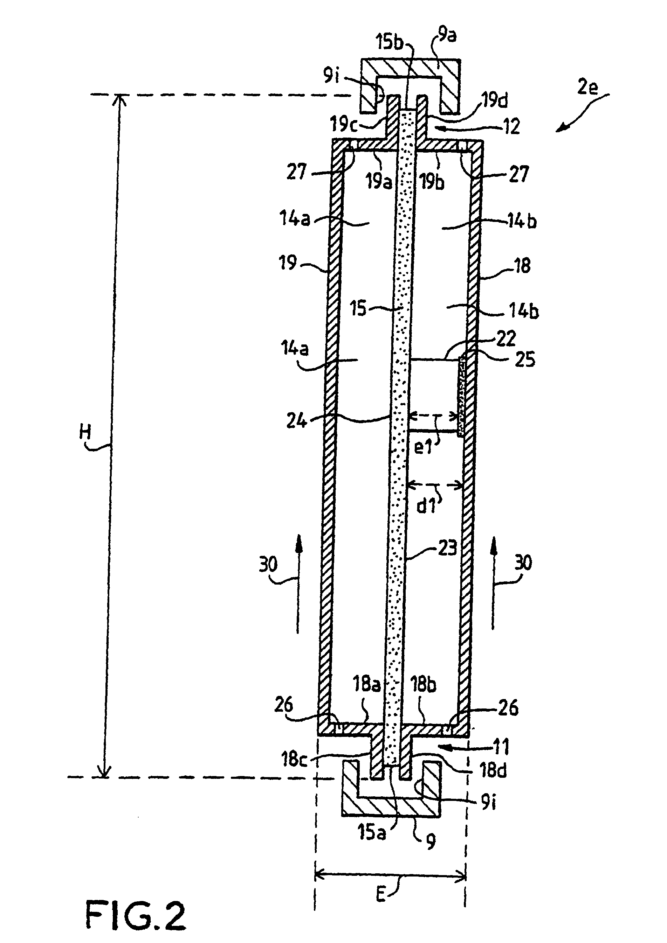

La figure 2 montre de manière simplifiée, en coupe, un exemple d'une structure classique de module électronique, telle qu'on peut la trouver par exemple dans le brevet GB-A-2 270 207.

Le module électronique 2e comprend deux capots 18, 19, par exemple en aluminium, d'épaisseur de l'ordre de 1 millimètre. L'aluminium est un matériau particulièrement intéressant du point de vue de la masse embarquée, en ce qu'il présente à la fois une faible densité et une très bonne rigidité mécanique même en faible épaisseur ; il présente aussi une conductibilité thermique moyenne, bien que très inférieure à celle du cuivre.

Une carte de circuit imprimé 15 est disposée dans l'espace délimité par les deux capots 18, 19. Elle est enserrée à sa périphérie par les bords des capots. La carte de circuit imprimé 15 porte les différents composants d'un circuit électronique, parmi lesquels au moins un composant 22 produisant une chaleur importante en fonctionnement (un microprocesseur puissant par exemple)

Dans l'exemple de la figure 2 le composant 22 présente une épaisseur e1 qui correspond sensiblement à une distance d1 entre l'intérieur du premier capot 18 et la face du circuit imprimé qui porte le composant (face 23). Le composant 22 est ainsi pratiquement en contact direct avec le premier capot 18, par l'intermédiaire par exemple d'une couche adaptatrice ou interface thermique 25 qui favorise le contact thermique et qui est électriquement isolante (élastomère ou résine époxy).

Ainsi les capots 18, 19 et particulièrement le premier capot 18 dans l'exemple représenté, en plus de leur fonction de protection du circuit imprimé 15 et de blindage électrostatique, assurent une fonction de dissipateur thermique.

Les calories transmises au capot sont elles-mêmes évacuées par conduction vers les glissières 9, 9a du rack, puis vers les parois du rack ; elles sont évacuées aussi par convection, grâce à l'air de refroidissement 30 provenant de la ventilation citée plus haut. Une ventilation intérieure des modules électroniques 2a à 2e peut être ajoutée, en aménageant des ouvertures inférieures et supérieures 26, 27 respectivement dans les parois basses et hautes 18a, 18b et 19a, 19b des capots.

Même en combinant les trois moyens ci-dessus cités, l'évacuation des calories peut ne pas être suffisante avec les composants actuels. L'un des buts de la présente invention est d'améliorer cette évacuation.

L'invention propose à cet effet un module électronique du type destiné à fonctionner dans un rack, comportant, au moins une carte de circuit imprimé, au moins un capot de protection définissant un logement pour la carte, au moins un composant produisant de la chaleur en fonctionnement et monté par sa face inférieure sur la carte, et une liaison thermique entre une face supérieure du composant et le capot, caractérisé en ce que la liaison thermique comprend un dispositif à haute conductibilité thermique interposé entre la face supérieure du composant et le capot, ce dispositif ayant une surface supérieure à celle du composant et ayant une conductibilité thermique supérieure à celle du capot.

Par le mot « interposé », il faut comprendre que le dispositif se trouve au moins en partie placé en série entre le composant et le capot dans le circuit thermique d'écoulement des calories du composant vers le capot. Et ceci même si le dispositif à haute conductibilité thermique comporte également une partie qui évacue la chaleur directement vers l'air naturel ou l'air de circulation forcée qui se trouve à l'extérieur du capot. Cependant, dans une réalisation préférentielle, le dispositif à haute conductibilité thermique est complètement interposé physiquement entre le composant et le capot et il s'applique par toute sa surface (supérieure à celle du composant) contre ce capot.

Par le terme dispositif à haute conductibilité thermique ou en abrégé «dispositif HCT», il faut comprendre tout dispositif ou élément présentant une conductibilité thermique meilleure que celle du matériau dont est constitué un capot chargé d'évacuer les calories, de façon à permettre d'égaliser ou de tendre à égaliser les températures en tous points d'une surface du capot avec laquelle ce dispositif HCT peut être mis en contact. Il peut s'agir par exemple, quand le capot est en aluminium, d'éléments à base d'un ou plusieurs matériaux dont la conductibilité thermique est égale ou supérieure à celle du cuivre, ou encore de dispositifs qui mettent en oeuvre des changements de phase d'un élément solide, liquide, ou gazeux permettant des transports d'énergie importants; certains de ces derniers dispositifs sont connus notamment sous le nom de « Caloducs » et peuvent être constitués par une plaque creuse contenant un liquide, le refroidissement reposant sur l'énergie consommée par le changement de phase liquide-gaz en circuit fermé dans la plaque creuse. Dans ce cas, on comprendra qu'on parle d'une conductibilité thermique équivalente, correspondant au pouvoir d'évacuation de chaleur : la conductibilité équivalente est celle d'un matériau fictif qui, avec les mêmes dimensions que le dispositif (le caloduc par exemple) aurait le même pouvoir d'évacuation de chaleur.

L'application d'un dispositif HCT sur une zone d'un capot rend cette zone apte à mieux conduire la chaleur, et en quelque sorte à mieux la distribuer au reste du capot qui, bien que moins bon conducteur thermique, bénéficie alors d'une plus grande surface intéressée par cette conduction. Il en résulte globalement un accroissement de la conductibilité thermique du capot, dans un rapport très supérieur à celui de l'accroissement de la masse du capot résultant de la présence du dispositif HCT.

L'invention sera mieux comprise, et d'autres caractéristiques et avantages qu'elle présente apparaîtront à la lecture de la description qui suit, faite à titre d'exemple non limitatif en référence aux figures annexées, parmi lesquelles :
- la figure 1 déjà décrite représente une baie ou rack d'un type connu contenant des modules électroniques classiques ;
- la figure 2 déjà décrite représente par une vue en coupe, la structure d'un module électronique montré à la figure 1 ;
- la figure 3 est une vue en coupe d'un module électronique selon l'invention ;
- la figure 4 est une vue en coupe d'un module électronique dans une autre forme de réalisation de l'invention ;
- la figure 5 montre par une vue en coupe, un mode de réalisation d'un dispositif à haute conductibilité thermique suivant l'invention, disposé sur un capot représenté à la figure 3 ;
- la figure 6a est une vue en coupe représentant un capot montré à la figure 5, dans lequel est réalisée une ouverture en vis à vis d'un dispositif à haute conductibilité thermique ;
- la figure 6b est une vue en coupe représentant le capot et le dispositif à haute conductibilité thermique montré à la figure 6a, mais avec un positionnement différent de ce dernier ;
- la figure 6c est une vue en coupe semblable à la figure 6a, et montrant en outre que le dispositif à haute conductibilité thermique est muni d'ailettes de refroidissement ;
- la figure 7 est une vue en coupe du capot montré à la figure 5, représentant une forme de réalisation de l'invention dans laquelle un dispositif à haute conductibilité thermique fait partie intégrante du capot.

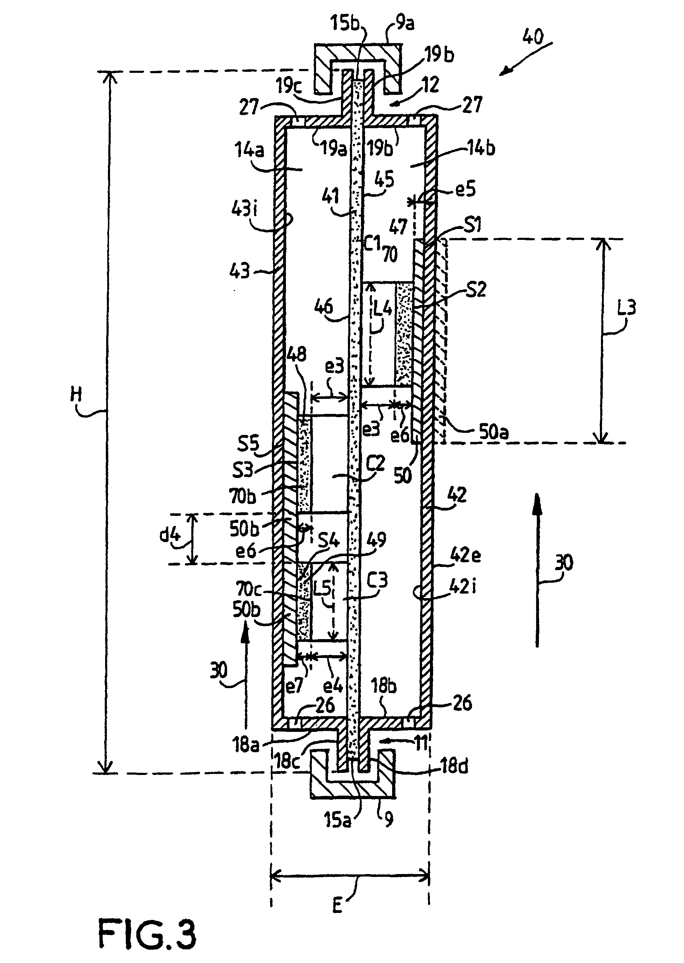

La figure 3 représente un module électronique 40 suivant l'invention, par une vue en coupe semblable à celle de la figure 2.

Le module 40 comporte une carte de circuit imprimé 41 entre deux capots 42, 43 en aluminium par exemple, semblables à ceux de la figure 22.

La carte 41 porte des composants parmi lesquels les composants dissipatifs C1, C2, C3 répartis ici sur les deux faces 45, 46 de la carte.

Selon l'invention, un (ou éventuellement plusieurs) dispositif à haute conductibilité thermique, ou dispositif HCT, 50, 50b est interposé en série (dans le sens de l'évacuation de chaleur du composant vers le capot) entre la face supérieure de certains composants (face opposée à la face inférieure tournée vers la carte) et le capt.

Un matériau à relativement bonne conductibilité thermique (quoique très inférieure à celle du dispositif HCT), peut remplir l'intervalle entre le composant et le dispositif HCT 50 ou 50b lorsque la hauteur du composant et la conformation du boîtier et du dispositif HCT ne permettent pas que la face supérieure du composant touche le dispositif HCT en même temps que le dispositif HCT touche le capot. Les matériaux ou produits les plus couramment utilisés pour assurer cette liaison thermique, sont par exemple des élastomères chargés de particules conductrices de la chaleur, des résines, des graisses, colles, gels et traitements de surfaces. Il est à noter que l'on trouve maintenant des feuilles du type à changement de phase, constituées d'un film support portant un revêtement qui change d'état à une température donnée, ce qui lui permet de combler les irrégularités microscopiques et d'améliorer le contact thermique

Le dispositif HCT 50 a notamment pour fonction d'uniformiser ou au moins de réduire fortement les différences de température présentées par une surface avec laquelle il est en contact. A cette fin, le premier capot 42 (mais aussi le second capot 43 dans l'exemple) étant fabriqué à partir d'aluminium, le dispositif HCT 50 peut être réalisé par exemple en cuivre. Mais le dispositif HCT peut aussi être réalisé en tout autre matériau ayant une conductibilité thermique supérieure à celle du matériau à partir duquel est réalisé le capot qui le porte ; on peut considérer que sa mise en oeuvre conformément à l'invention devient pleinement intéressante quand sa conductibilité thermique est égale ou supérieure à 1,5 fois celle du matériau dont est fait (ou à partir duquel est fait) ce capot.

Parmi les matériaux offrant une conductibilité thermique encore supérieure à celle du cuivre, on peut citer par exemple des matériaux à base de graphite à haute conductivité notamment le graphite pyrrolique, ou des matériaux composites du type carbone/carbone, ou encore des matériaux du type ayant une structure formée par un substrat portant un dépôt de diamant. Il est à noter enfin que le dispositif HCT 50 peut aussi être réalisé à partir d'une structure mettant en oeuvre le changement de phase d'un élément liquide, solide ou gazeux, comme déjà mentionné plus haut et comme il sera davantage expliqué dans une suite de la description.

Le dispositif HCT 50 se présente sous la forme d'une plaque dont une épaisseur e5 comprise par exemple entre 1 et 4 millimètres, est choisie d'autant plus grande que les puissances thermiques à évacuer sont élevées.

Le dispositif HCT 50, c'est à dire la plaque HCT 50 est prévue de préférence pour avoir une surface S1, plus grande que la surface S2 du composant. Des essais ont donné un résultat très satisfaisant avec une surface S1 de la plaque HCT 50 d'environ 30 cm² (pour S2 de l'ordre de 8 cm²), et une épaisseur e5 de l'ordre de 1, 5 millimètre. Ces dimensions de la plaque HCT sont données uniquement à titre indicatif et ne constituent pas un exemple limitatif, elles peuvent être adaptées aux puissances dissipées ; de plus, il est à noter qu'une diminution d'épaisseur e5 de la plaque HCT peut être compensée par une augmentation de sa surface et réciproquement.

Il est possible d'augmenter encore l'efficacité de l'évacuation des calories, en conférant à la surface S1 de la plaque HCT 50 une forme allongée, et en l'orientant pour que sa plus grande dimension soit dans la direction la plus favorable à son refroidissement. Cette plus grande dimension peut être par exemple sensiblement parallèle au flux d'air de refroidissement 30 ; ou bien parallèle à la hauteur H du module électronique dans le cas ou les glissières 9, 9a constituent une source froide, ou bien encore être orientée différemment notamment en fonction d'essais et/ou d'une configuration particulière.

La plaque HCT 50 peut être réalisée et montée directement (comme représenté à la figure 3) sur le capot 42, en usine, c'est à dire dans une même étape industrielle que celle de la fabrication du capot 42, ce qui permet d'obtenir un excellent contact thermique. Si la plaque HCT 50 doit être rapportée sur le capot 42 après la fabrication de ce dernier, il peut être avantageux de le faire par l'intermédiaire d'une couche dite d'interface thermique (non représentée) pour garantir la qualité du contact.

Bien entendu, il est possible de disposer si nécessaire plusieurs dispositif HCT 50, 50a sur un même capot 42, 43.

Les deuxième et troisième composants C2 et C3 montés sur la seconde face 46, permettent d'illustrer une autre version de l'invention, dans laquelle un dispositif ou plaque HCT unique repéré 50b sert à favoriser l'évacuation des calories produites par plusieurs composants. Les différences de hauteur des composants C2 et C3 sont rattrapées par le matériau de remplissage interposé entre la face supérieure du composant et le dispositif HCT 50b.

Par exemple, la plaque HCT 50b dans cette configuration présente une surface S5 de l'ordre de 42 cm², qui permet d'évacuer les calories produites par les deux composants C2, C3 avec une efficacité comparable à celle ci-dessus décrite à propos du composant C1.

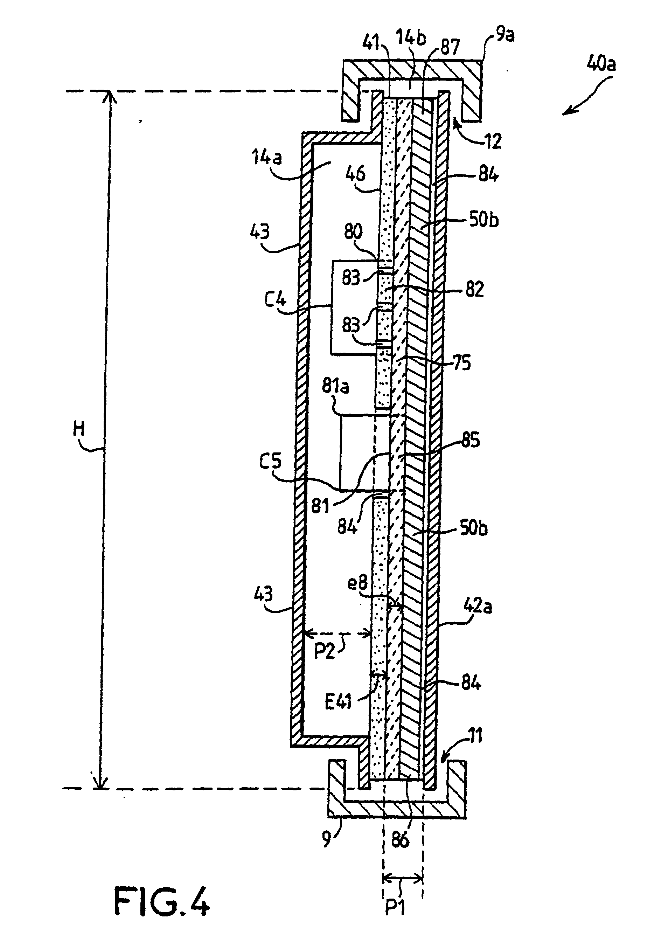

La figure 4 représente un module électronique 40a dans la configuration qu'il aurait si l'évacuation de chaleur était faite à partir de la face inférieure des composants.

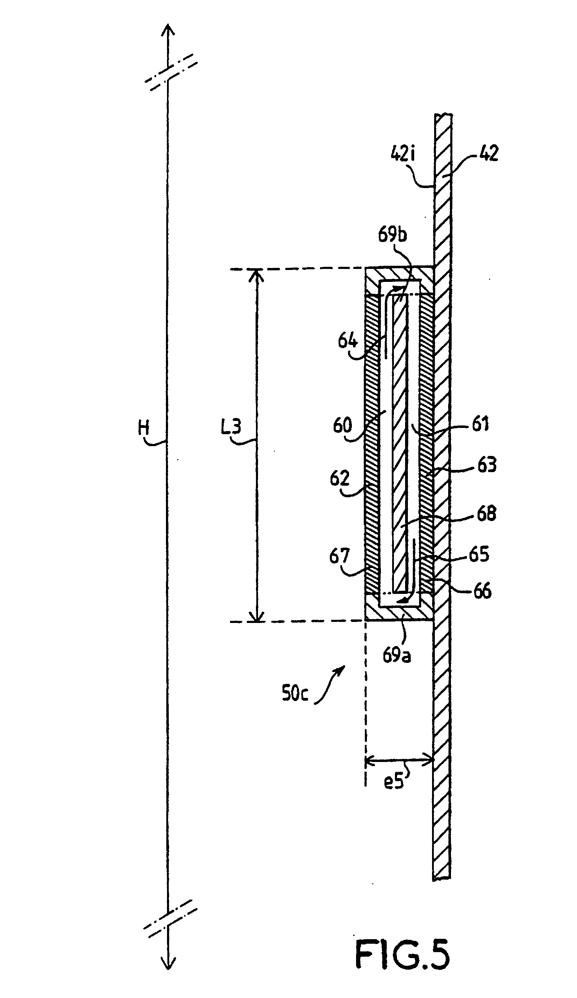

La figure 5 est une vue en coupe d'un dispositif HCT repéré 50c, du type appelé plus haut « Caloduc », mettant en oeuvre un effet de changement de phase d'un élément, d'un liquide par exemple et par exemple de l'eau. Le dispositif HCT 50c peut être utilisé sur l'un ou l'autre des capots 42, 42a, 43. Dans l'exemple il est représenté monté sur le premier capot 42 (partiellement représenté sur la figure 5), à une même position par exemple et avec une même fonction que dans le cas du dispositif HCT 50 montré à la figure 3.

Le dispositif HCT 50c est donc monté sur la face intérieure 42i du premier capot 42. Il se présente sous une forme semblable à celle de la plaque HCT 50, avec par exemple une même longueur L3 (parallèle à la hauteur H du capot) mais cependant avec une épaisseur e5 peut être plus importante, de l'ordre par exemple de 3 millimètres, en fonction notamment des moyens d'usinage utilisés. Dans l'exemple non limitatif de la description, il comporte deux canaux 60, 61 communiquants et parallèles, qui s'étendent parallèlement au plan du capot 42, et qui constituent un circuit fermé. De ces deux canaux, un premier canal 60 est en contact avec une paroi 62 chaude destinée à recevoir des calories délivrées par la première liaison thermique 47 montrée à la figure 3. Le second canal 61 est lui en contact avec une seconde paroi 63 froide qui elle est en contact avec le capot 42.

Dans ces conditions, une quantité d'eau contenue dans le premier canal 60 passe en phase vapeur quand elle est chauffée par la première paroi 62, et sous forme de vapeur (symbolisée par une flèche 64) elle passe dans le second canal 61 plus froid, où la vapeur se condense et sous forme d'eau 65 retourne dans le premier canal 60.

Le circuit fermé constitué par les deux canaux ou micro-canaux 60, 61, peut aisément être réalisé de façon industrielle dans du cuivre ou tout autre matériau ayant une bonne conductibilité thermique. Ces deux canaux peuvent être formés par des gorges étroites usinées par exemple dans des plaques 66, 67, en cuivre, séparées par une plaque intermédiaire 68, et fermés par des pièces d'extrémité 69a, 69b. Des gorges étroites de 1 ou 2 millimètres par exemple pour fermer les canaux, permettent de reproduire plusieurs tels circuits fermés, en parallèles, dans les dimensions allouées au dispositif HCT 50c.

La très grande capacité de transfert de calories que possèdent les systèmes à changement de phase tel que le dispositif HCT 50c, leur permet de conférer une distribution homogène, sensiblement uniforme, des températures présentées par toute la surface du capot 42 sur laquelle ils sont appliqués.

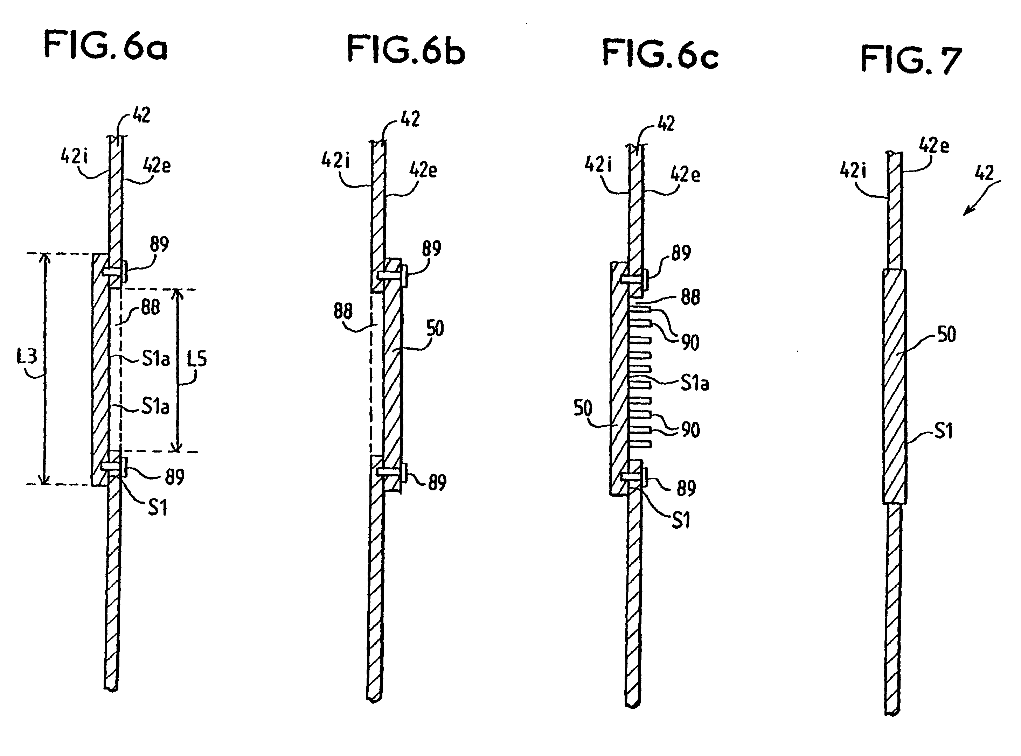

L'augmentation de la masse d'un capot 42, 42a, 43 par la présence d'un dispositif HCT, peut être compensée en réalisant dans ce capot une ouverture en vis à vis d'au moins un dispositif HCT, comme représenté à la figure 6a.

La figure 6a représente de façon schématique et partiellement un capot, tel que par exemple le premier capot 42, par une vue en coupe semblable à celle de la figure 5. Le capot 42 porte l'un quelconque des dispositifs HCT ci-dessus décrits, le premier dispositif HCT 50 par exemple montré à la figure 3. Dans l'exemple représenté le dispositif HCT 50 est monté sur la face intérieure 42i du capot 42. Suivant une caractéristique de l'invention, le capot 42 comporte une (ou plusieurs) ouverture 88 formée en regard du dispositif HCT 50. L'ouverture 88 peut comporter des dimensions (dont seule une longueur L5 est représentée) un peu inférieures à celles du dispositif HCT (dont seule la longueur L3 est représentée), de manière que ce dernier ferme l'ouverture 88. Une partie du dispositif HCT est en contact direct, à l'extérieur du capot, avec l'air extérieur. Le dispositif HCT est cependant relié thermiquement au capot 42 au moins à la périphérie de l'ouverture 88, de sorte que le capot contribue pour une part à l'évacuation de la chaleur du composant. Là encore, la surface du dispositif HCT est supérieure à celle du composant avec lequel il est en contact (de préférence direct).

L'exemple non limitatif de la figure 6a représente un cas où le dispositif HCT 50 est rapporté sur le capot 42, après fabrication de celui-ci, et dans l'exemple il est fixé par des vis 89 sur la face intérieure 42i de ce capot.

La figure 6b est une vue du capot 42 semblable à celle de la figure 6a, montrant également une ouverture 88. Mais dans le cas de la figure 6b, le dispositif HCT 50 est rapporté sur le capot 42 par l'extérieur, c'est à dire fixé sur la face extérieure 42e de ce capot. Le dispositif HCT 50 peut ainsi être rapporté sur le capot 42 par l'extérieur ou bien par l'intérieur (fig. 6a), pour des questions notamment de facilité de démontage du capot.

La figure 6c est une vue du capot 42 qui diffère de celle de la figure 6a uniquement par le fait que le dispositif HCT 50 comporte des ailettes de refroidissement 90. Le dispositif HCT 50 est fixé sur la face intérieure 42i du capot 42, et la partie S1a de sa surface S1 qui débouche sur l'extérieur grâce à l'ouverture 88, est munie d'ailettes 90 qui tendent à favoriser son refroidissement.

La figure 7 est une vue en coupe d'un capot, le capot 42 par exemple, et elle représente une autre manière de disposer un dispositif HCT 50. Dans cette version, le dispositif HCT 50 est disposé dans le prolongement de la plaque qui forme le capot, et il fait partie intégrante du capot ; le dispositif HCT peut soit être obtenu directement par usinage, soit par exemple être réalisé à part et solidarisé au capot par soudure après par exemple l'avoir encastré dans une ouverture (non représentée) pratiquée dans ce capot. On comprend que dans ce cas, on considérera que le dispositif est inséré au moins pour partie en série entre le composant et le capot, par sa périphérie soudée au capot.

Bien entendu, dans cette dernière version de l'invention, le dispositif HCT 50 peut éventuellement être muni d'ailettes 90 (non représentées à la figure 7) sur éventuellement toute sa surface S1.

## Revendications

1. Module électronique du type destiné à fonctionner dans un rack (1), comportant, au moins une carte de circuit imprimé (15), au moins un capot de protection (42) définissant un logement pour la carte, au moins un composant (C1) produisant de la chaleur en fonctionnement et monté par sa face inférieure sur la carte, et une liaison thermique entre une face supérieure du composant et le capot, **caractérisé en ce que** la liaison thermique comprend un dispositif à haute conductibilité thermique (50) interposé entre la face supérieure du composant et le capot, ce dispositif ayant une surface (S1) supérieure à celle (S2) du composant et ayant une conductibilité thermique supérieure à celle du capot.

2. Module électronique selon la revendication 1, **caractérisé en ce que** le dispositif à haute conductibilité thermique est constitué par une plaque de matière à grande conductibilité thermique.

3. Module électronique selon la revendication 2, **caractérisé en ce que** le dispositif à haute conductibilité thermique est constitué par une plaque creuse de type caloduc fonctionnant sur le principe de changement de phase en circuit fermé d'un liquide contenu dans la plaque creuse.

4. Module électronique suivant la revendication 1, **caractérisé en ce que** le dispositif à haute conductibilité thermique (50, 50a, 50b, 50c) présente une conductibilité thermique égale ou supérieure à 1,5 fois celle du matériau à partir duquel est réalisé le capot (42, 42a, 43) qui le porte.

5. Module électronique suivant l'une des revendications précédentes, **caractérisé en ce qu'**au moins un dispositif à haute conductibilité thermique (50, 50a, 50b, 50c) présente une forme allongée de manière à comporter une plus grande dimension (L3), afin de permettre une orientation de cette plus grande dimension (L3) la plus favorable au refroidissement du dispositif à haute conductibilité thermique (50, 50a, 50b, 50c).

6. Module électronique suivant l'une des revendications précédentes, **caractérisé en ce qu'**un capot (42, 43) portant un dispositif à haute conductibilité thermique (50, 50a, 50b, 50c) comporte une ouverture (88) formée sensiblement en vis à vis du dispositif à haute conductibilité thermique.

7. Module électronique suivant l'une quelconque des revendications 1 à 6, **caractérisé en ce qu'**un dispositif à haute conductibilité thermique (50) fait partie intégrante d'un capot (42, 42a, 43).

## Patentansprüche

1. Elektronischer Modul, der in einem Einschub (1) betrieben werden soll und mindestens eine Druckschaltungskarte (15), mindestens eine Schutzschale (42), die einen Platz für die Karte definiert, mindestens ein Bauelement (C1), das im Betrieb Wärme erzeugt und mit seiner Unterseite auf der Karte montiert ist, sowie eine Wärmebrücke zwischen einer Oberseite des Bauelements und der Schale aufweist, **dadurch gekennzeichnet, daß** die Wärmebrücke eine Vorrichtung mit hoher Wärmeleitfähigkeit (50) enthält, die zwischen der Oberseite des Bauelements und der Schale eingefügt ist, wobei diese Vorrichtung eine größere Oberfläche (S1) als die (S2) des Bauelements sowie eine größere Wärmeleitfähigkeit als die Schale besitzt.

2. Elektronischer Modul nach Anspruch 1, **dadurch gekennzeichnet, daß** die Vorrichtung hoher Wärmeleitfähigkeit von einer Platte aus einem Material großer Wärmeleitfähigkeit gebildet wird.

3. Elektronischer Modul nach Anspruch 2, **dadurch gekennzeichnet, daß** die Vorrichtung hoher Wärmeleitfähigkeit von einer hohlen Platte vom Caloduc-Typ gebildet wird, die nach dem Prinzip des Phasenwechsels im geschlossenen Kreislaufs einer in der hohlen Platte enthaltenen Flüssigkeit funktioniert.

4. Elektronischen Modul nach Anspruch 1, **dadurch gekennzeichnet, daß** die Vorrichtung hoher Wärmeleitfähigkeit (50, 50a, 50b, 50c) eine Wärmeleitfähigkeit besitzt, die mindestens den 1,5-fachen Wert der des Materials aufweist, aus dem die sie tragende Schale (42, 42a, 43) hergestellt ist.

5. Elektronischer Modul nach einem der vorstehenden Ansprüche, **dadurch gekennzeichnet, daß** mindestens eine Vorrichtung hoher Wärmeleitfähigkeit (50, 50a, 50b, 50c) eine längliche Form mit einer großen Abmessung (L3) besitzt, sodaß eine Ausrichtung dieser Seite großer Abmessung (L3) möglich wird, die für die Kühlung der Vorrichtung hoher Wärmeleitfähigkeit (50, 50a, 50b, 50c) am günstigsten ist.

6. Elektronischer Modul nach einem der vorstehenden Ansprüche, **dadurch gekennzeichnet, daß** eine Schale (42, 43), die eine Vorrichtung hoher Wärmeleitfähigkeit (50, 50a, 50b, 50c) trägt, eine Öffnung (88) besitzt, die im wesentlichen vor der Vorrichtung hoher Wärmeleitfähigkeit liegt.

7. Elektronischer Modul nach einem beliebigen der Ansprüche 1 bis 6, **dadurch gekennzeichnet, daß** eine Vorrichtung hoher Wärmeleitfähigkeit (50) integraler Bestandteil einer Schale (42, 42a, 43) ist.

## Claims

1. Electronic module of the type intended to operate in a rack (1), comprising at least one printed circuit board (15), at least one protective cover (42) defining a housing for the board, at least one component (C1) producing heat in operation and mounted via its bottom face on the board, and a thermal link between a top face of the component and the cover, **characterized in that** the thermal link comprises, interposed between the top face of the component and the cover, a device (50) having a high thermal conductivity, this device having an area (S1) greater than that (S2) of the component and having a thermal conductivity greater than that of the cover.

2. Electronic module according to Claim 1, **characterized in that** the device having a high thermal conductivity consists of a plate of material of great thermal conductivity.

3. Electronic module according to Claim 2, **characterized in that** the device having a high thermal conductivity consists of a hollow plate of the heat-pipe type, operating on the principle of a change of phase, in a closed circuit, of a liquid contained in the hollow plate.

4. Electronic module according to Claim 1, **characterized in that** the device (50, 50a, 50b, 50c) having a high thermal conductivity has a thermal conductivity equal to or greater than 1.5 times that of the material from which the cover (42, 42a, 43) bearing it is made.

5. Electronic module according to one of the preceding claims, **characterized in that** at least one device (50, 50a, 50b, 50c) having a high thermal conductivity has an elongate shape so as to have a larger dimension (L3), in order to allow this larger dimension (L3) to be oriented the most favourably for cooling the device (50, 50a, 50b, 50c) having a high thermal conductivity.

6. Electronic module according to one of the preceding claims, **characterized in that** a cover (42, 43) bearing a device (50, 50a, 50b, 50c) having a high thermal conductivity has an opening (88) formed substantially opposite the device having a high thermal conductivity.

7. Electronic module according to any one of Claims 1 to 6, **characterized in that** a device (50) having a high thermal conductivity forms an integral part of a cover (42, 42a, 43).
